# EUROPÄISCHE PATENTSCHRIFT

(11) **EP 2 693 493 B1**
(45) Veröffentlichungstag und Bekanntmachung des Hinweises auf die Patenterteilung: **02.12.2020**
(21) Anmeldenummer: 12005552.0
(22) Anmeldetag: 31.07.2012
(51) Int. Cl.: H01L 31/048, H01L 31/052

(54) **Solarzelleneinheit**
Solar cell unit
Unité de cellules solaires

(43) Veröffentlichungstag der Anmeldung: 05.02.2014
(73) Patentinhaber: AZUR SPACE Solar Power GmbH, 74072 Heilbronn (DE)
(72) Erfinder: Zrinscak, Ivica, 74074 Heilbronn (DE); Khorenko, Victor, 74196 Neuenstadt a. K. (DE)
(74) Vertreter: Koch Müller Patentanwaltsgesellschaft mbH

(56) Entgegenhaltungen:
- EP-A1- 2 073 279
- EP-A1- 2 194 584
- EP-A1- 2 278 631
- WO-A1-2010/137687
- DE-A1-102011 084 054
- US-A1- 2009 020 152
- US-A1- 2011 155 217
- US-A1- 2011 247 684

## Beschreibung

Die Erfindung betrifft eine Solarzelleneinheit gemäß dem Oberbegriff des Patentanspruchs 1.

Aus der EP 2 073 279 A1 ist ein Solarzellenmodul bekannt, bei dem ein als Solarzelle ausgebildeter Halbleiterkörper auf einem Träger angeordnet ist. Um den Halbleiterkörper und insbesondere dessen Seitenflächen vor Umgebungseinflüssen zu schützen, die zu einer Degradation der elektrischen Parameter führen, wird um den Halbleiterkörper an vier Seiten ein Rahmen angeordnet und mit einem transparenten Deckel abgeschlossen. Anschließend wird der verbleibende Zwischenraum mit einer transparenten Vergussmasse aufgefüllt und ein optisches Element angebracht.

Aus der EP 1 953 825 A2 ist eine weitere Solarzelleneinheit bekannt. Hierbei wird auf einem Träger ein als Solarzelle ausgebildeter Halbleiterkörper angeordnet. Anschließend werden zum Schutz des Halbleiterkörpers eine Dichtfolie und ein aus mehreren Teilen bestehendes Gehäuse, welches auch ein optisches Element umfasst, in einem mehrstufigen Prozess auf dem Träger angeordnet.

Aus der DE 10 2009 006 286 A1 ist eine Solarzelleneinheit bekannt, welches eine Vielzahl von einzelnen Solarzellen auf einem Träger aufweist. Unter anderem ist oberhalb der Solarzelle ein optisches Element, welches auch als sekundäres optisches Element bezeichnet "SOE" wird, angeordnet. Das optische Element leitet das durch eine Fresnellinse fokussierte Licht der Sonne auf die Oberfläche der Solarzelle. Mittels der fokussierenden Anordnung lassen sich mit wenigen kleinen Solarzellen, welche einen Wirkungsgrad bis zu 40% und darüber aufweisen, großflächige Solarzelleneinheiten aufbauen.

Ferner sind aus der US 2009 / 020152 A1, der EP 2 194 584 A1, der 2 278 279 A1, der DE 10 2011 084 054 A1, der US 2011 /247684 A1, der WO 2010 / 137687 A1 und der US 2011 / 155 217 A1 weitere Solarzelleneinheiten bekannt.

Vor diesem Hintergrund besteht die Aufgabe der Erfindung darin, eine Vorrichtung anzugeben, die den Stand der Technik weiterbildet.

Die Aufgabe wird durch eine Solarzelleneinheit mit den Merkmalen des Patentanspruchs 1 gelöst. Vorteilhafte Ausgestaltungen der Erfindung sind Gegenstand von Unteransprüchen.

Gegenstand der Erfindung ist eine Solarzelleneinheit wie im unabhängigen Anspruch 1 definiert.

Es sei angemerkt, dass es sich bei der Solarzelle vorzugsweise um eine III-V Halbleitersolarzelle auf GaAs Basis handelt und die Solarzelle höchst vorzugsweise als stapelförmig angeordnete Mehrfachsolarzelle ausgebildet ist und unter anderem mittels Nutzung von UV-Uchtanteilen Wirkungsgrade oberhalb 30% aufweist. Derartige Solarzelleneinheiten werden, unter anderem wegen den im Vergleich zu den Siliziumsolarzellen höheren Herstellkosten, bevorzugt in sogenannten CPV-Systemen eingesetzt. In den CPV-Systemen wird das Sonnenlicht um Faktoren oberhalb von 50 gebündelt.

Hierbei wird das mittels eines primären optischen Konzentrators bzw. Elements gebündelte Licht auf ein sekundäres optisches Element geleitet. Das Primäre Element ist oberhalb des sekundären optischen Elements angeordnet. Von dem sekundären optischen Element wird das Licht durch die Polymerkleberschicht hindurch auf die Vorderseite der Solarzelle geleitet.

Um die optischen Verluste gering zu halten, muss die Polymerkleberschicht neben einer hohen UV-Beständlgkeit auch in dem gesamten auszunutzenden Spektralbereich besonders transparent ausgebildet sein. Außerdem werden durch die hohe Konzentration des Sonnenlichtes hohe Temperaturen von bis zu 120°C auf der Vorderseite der Solarzelle erzielt, d. h. die Polymerkleberschicht muss besonders temperatur- und alterungsbeständig ausgeführt sein.

Ein Vorteil der erfindungsgemäßen Vorrichtung ist es, dass das sekundäre optische Element mit Ausnahme der Hauptkavität eine plane Oberfläche aufweist und sich hierdurch einfach und kostengünstig herstellen lässt.

Indem die Größe der Hauptkavität auf die Dicke und Größe der Solarzelle und deren Kontaktstreifen angepasst ist, lässt sich nach dem Einbringen der Solarzelle und den Kontaktstreifen in die Hauptkavität eine nahezu plane Unterseite des sekundären optischen Elements erzeugen. Erfindungsgemäß steht die Rückseite des Halbleiterkörpers aus der Oberfläche hervor, vorzugsweise um weniger als 1 mm, höchst vorzugsweise um weniger als 0,05 mm.

Ein Vorteil der Anpassung der Hauptkavität in Größe und Form an die Größe der Solarzelle ist es, dass sich ein hoher Transmissionsgrad des auf das sekundäre optische Element einfallende Lichts erzielen lässt. Indem zwischen der Unterseite des sekundären optischen Elements und der Oberseite des Trägers bzw. der Vorderseite der Solarzelle eine Polymerkleberschicht, die vorzugsweise eine Kunststoffverbindung und höchst vorzugsweise eine Silikonverbindung umfasst, ausgebildet ist, lässt sich ohne weitere Verbindungsmittel eine kraftschlüssige Verbindung zwischen dem sekundären optischen Element und dem Halbleiterkörper und den Kontaktstreifen auf einfache und kostengünstige Welse herstellen. Die Polymerkleberschicht ist vorzugsweise kissenartig und formschlüssig bis an den ersten Kontaktstreifen und / oder den zweiten Kontaktstreifen und bis an die Vorderseite des Halbleiterkörpers ausgebildet. Es versteht sich, dass zwischen einerseits der Vorderseite der Solarzelle und andererseits der Unterseite des sekundären optischen Elements in der Hauptkavität und insbesondere zu der ersten Grundfläche in der Hauptkavität, die Polymerkleberschicht eine geringe Dicke, vorzugsweise unterhalb 2 mm, höchst vorzugsweise unterhalb 0,5 mm ausgebildet. Es versteht sich, dass sich mit einer geringer werdenden Dicke von der oberhalb der Vorderseite des Halbleiterkörpers ausgebildeten Polymerkleberschicht eine Erhöhung des Transmissionsgrades einhergeht.

Untersuchungen haben gezeigt, dass die Polymerkleberschicht dichtende Eigenschaften aufweist und die Vorderseite des Halbleiterkörpers und die in der Hauptkavität ausgebildeten Seitenflächen des Halbleiterkörpers durch die Polymerkleberschicht vor Umgebungseinflüssen geschützt werden. Es ist bevorzugt, den nach dem Einbringen des Halbleiterkörpers und den Kontaktstreifen verbleibende Raum in der Hauptkavität vollständig mit der Polymerkleberschicht auszufüllen.

Erfindungsgemäß weist die Hauptkavität eine um die erste Grundfläche angeordnete zweite Grundfläche und / oder dritte Grundfläche auf, wobei zwischen der ersten Grundfläche und der zweiten Grundfläche eine erste Teilkavität und / oder zwischen der erste Grundfläche und der dritten Grundfläche eine zweite Teilkavität ausgebildet ist. Vorzugsweise sind die erste Tellkavltät und die zweite Teilkavität ausschließlich innerhalb der Hauptkavität ausgebildet. Ein Vorteil ist, dass mittels der Ausbildung von den beiden Teilkavitäten sich auch die bogenförmig ausgebildeten ersten Kontaktstreifen und zweiten Kontaktstreifen nahezu formschlüssig aufnehmen lassen. Indem die Größe und Form der beiden Teilkavitäten an die beiden Kontaktstreifen angepasst werden, wird das gesamte Volumen der Hauptkavität nur gering erhöht. Es sei angemerkt, dass bei einer Verwendung von Kontaktstreifen ohne bogenartige Erhöhung sich die Ausbildung von Teilkavitäten erübrigt.

In einer Weiterbildung weist die Unterseite des optischen Elements eine erste Ausformung auf, wobei die erste Ausformung als Zentrierhilfe ausgebildet Ist. In einer alternativen Ausführung ist eine zweite Ausformung ausgebildet, wobei vorzugsweise die erste Ausformung und / oder die zweite Ausformung aus der Unterseite hervorstehen. Ein Vorteil der Ausformungen ist es, dass sich bei einem Zusammenfügen der Solarzelleneinheit mit einer Unterlage bzw. einem Träger die Solarzelleneinheit zu der Unterlage exakt zentrieren lässt. Hierbei weist die Unterlage entsprechende Ausnehmungen auf.

In einer bevorzugten Ausführungsform ist das sekundäre optische Element in Form eines halben Ellipsoids oder ist ellipsenförmig ausgebildet und weist vorzugsweise einen umlaufenden absatzförmigen Kragen auf. In einer anderen Ausführungsform ist das sekundäre optische Element pyramidenstumpfförmig oder trichterförmig ausgebildet. Des Weiteren ist es bevorzugt, das sekundäre optische Element einstückig aus einem anorganischen Material, vorzugsweise aus einer Quarzglasverbindung, auszubilden. Ein Vorteil des anorganischen Material bzw. der Quarzglasverbindung ist die sehr gute UV-Transparenz und die außerordentliche hohe Temperaturstabilität sowie eine große mechanische und chemische Widerstandsfähigkeit im Vergleich zu einer organischen bzw. Kunststoff-Verbindung.

In einer Weiterbildung ist zwischen der ersten Grundfläche und der Polymerkleberschicht eine erste Haftvermittlerschicht ausgebildet. Vorzugsweise ist die erste Haftvermittlerschicht in der Hauptkavität des optischen Elements ausgebildet. In einer alternativen Ausführungsform ist die erste Haftvermittlerschicht an der gesamten Unterseite des sekundären optischen Elements ausgebildet und mit der Unterseite des sekundären optischen Elements stoffschlüssig verbunden. Untersuchungen haben gezeigt, dass sich die Haftung des sekundären optischen Elements und der Polymerkleberschicht mit der Ausbildung einer dünnen Haftvermittlerschicht wesentlich erhöhen und hierdurch die Zuverlässigkeit steigern lässt. In einer anderen Weiterbildung ist zwischen der Polymerkleberschicht und der Vorderseite des Halbleiterkörpers eine zweite Haftvermittlerschicht ausgebildet und die zweite Haftvermittlerschicht mit der Vorderseite des Halbleiterkörpers stoffschlüssig verbunden. Mit der Ausbildung der zweiten Haftvermittlerschicht lässt sich die Zuverlässigkeit weiter erhöhen. Es ist bevorzugt, die erste Haftvermittlerschicht und / oder die zweite Haftvermittlerschicht transparent und sehr dünn auszuführen, vorzugsweise beträgt die Dicke weniger als 0,5 mm, höchst vorzugsweise weniger als 0,05 mm.

Die Erfindung wird nachfolgend unter Bezugnahme auf die Zeichnungen näher erläutert. Hierbei werden gleichartige Teile mit identischen Bezeichnungen beschriftet. Die dargestellte Ausführungsformen sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1: eine Draufsicht auf eine erste erfindungsgemäße Ausführungsform einer Solarzelleneinheit,
- Figur 2: eine Querschnittsansicht entlang einer Linie II-II auf die Ausführungsform dargestellt in der Figur 1,
- Figur 3: eine Querschnittsansicht entlang einer Linie III-III auf die Ausführungsform dargestellt in der Figur 1,
- Figur 4: einen detaillierten Ausschnitt einer Querschnittsansicht entlang einer Linie IV-IV auf die Ausführungsform dargestellt in der Figur 1,
- Figur 5: eine perspektivische Ansicht auf eine zweite ungefügte Ausführungsform einer Solarzelleneinhelt,
- Figur 6: eine perspektivische Ansicht auf die zweite gefügte Ausführungsform dargestellt in der Figur 5,
- Figur 7: eine perspektivische Ansicht auf die dritte gefügte Ausführungsform einer Solarzelleneinheit,
- Figur 8: eine Querschnittsansicht entlang einer Linie V-V auf die Ausführungsform dargestellt in der Figur 7.

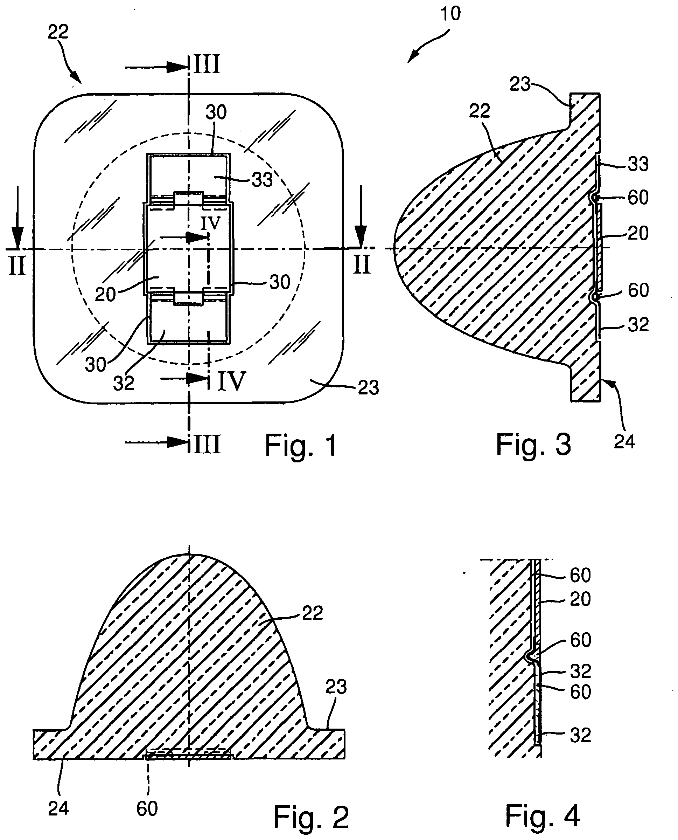

Die Abbildung der Figur 1 zeigt eine Solarzelleneinheit 10 mit einem als Solarzelle ausgebildeten Halbleiterkörper 20, einem sekundären optischen Element 22 in Form eines halben Ellipsoids mit einem umlaufenden kragenförmigen Wulst 23. Das sekundäre optische Element 22 weist eine Unterseite 24 mit einer in einem zentralen Bereich ausgebildeten Hauptkavität 30 auf. Mit Ausnahme der Hauptkavität 30 weist das sekundäre optische Element 22 an der Unterseite 24 eine plane Oberfläche auf. Der Halbleiterkörper 20 weist eine Vorderseite und eine Rückseite auf, wobei auf der Vorderseite des Halbleiterkörpers ein erster elektrischer Anschlusskontaktbereich und auf Rückseite des Halbleiterkörpers 20 ein zweiter elektrischer Anschlusskontaktbereich ausgebildet ist, und der erste elektrische Anschlusskontaktbereich mit einem ersten Kontaktstreifen 32 und mit einem zweiten Kontaktstreifen 33 elektrisch verschaltet ist.

In einem mittleren Bereich der Hauptkavität 30 ist eine erste plane Grundfläche 35 - nicht sichtbar ausgebildet. Die Hauptkavität 30 nimmt den Halbleiterkörper 30 mit dem ersten Kontaktstreifen 32 und dem zweiten Kontaktstreifen 33 auf. Die erste Grundfläche 35 ist oberhalb Vorderseite des Halbleiterkörpers 20 angeordnet und mit dem Halbleiterkörper 20 kraftschlüssig verbunden. Zwischen der ersten Grundfläche 35 und der Vorderseite des Halbleiterkörpers 20 als auch zwischen der die erste Grundfläche 35 umgebenden Hauptkavität 30 und dem ersten Kontaktstreifen 32 und dem zweiten Kontaktstreifen 33 ist eine Polymerkleberschicht 60 - nicht sichtbar - ausgebildet.

Die Abbildung der Figur 2 zeigt eine Querschnittsansicht entlang einer Linie II-II auf die Ausführungsform dargestellt in der Figur 1. Ferner zeigt die Abbildung der Figur 3 eine Querschnittsansicht entlang einer Linie III-III der Ausführungsform dargestellt In der Figur 1. Des Weiteren zeigt die Abbildung der Figur 4 einen detaillierten Ausschnitt der Querschnittsansicht entlang einer Linie IV-IV auf die Ausführungsform dargestellt In der Figur 1. Nachfolgend werden nur die Unterschiede zu der Darstellung in der Figur 1 erläutert. Es zeigt sich, dass mittels der Anpassung der Größe der Hauptkavität 30 an die Dicke und Größe des Halbleiterkörpers 20 und an den ersten Kontaktstreifen 32 und den zweiten Kontaktstreifen 33 eine plane Unterseite des sekundären optischen Elements 22 ausbildet. Der Raum zwischen der Hauptkavität 30 und der Vorderseite des Halbleiterkörpers bzw. den beiden Kontaktstreifen 32 und 33 wird von der die Polymerkleberschicht 60 gefüllt. Des Weiteren umfasst die Polymerkleberschicht 60 die Seitenflächen des Halbleiterkörpers 20 und die bogenförmigen Ausformungen der beiden Kontaktstrelfen 32 und 33. Insgesamt ist die Menge an Polymerkleberschicht 60 derart eingestellt, dass sich nach dem Fügen eine plane Oberfläche auch In dem Bereich der Hauptkavität 30 einstellt. Es versteht sich, dass die Rückseite des Halbleiterkörpers und die Unterseite der beiden Kontaktstreifen 32 und 33 nicht mit Teilen der Polymerkleberschicht 60 benetzt sind, um eine spätere elektrische Kontaktierung nicht zu behindern.

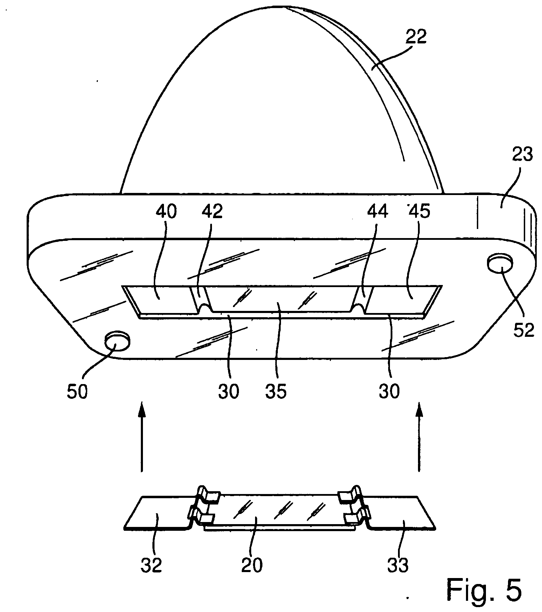

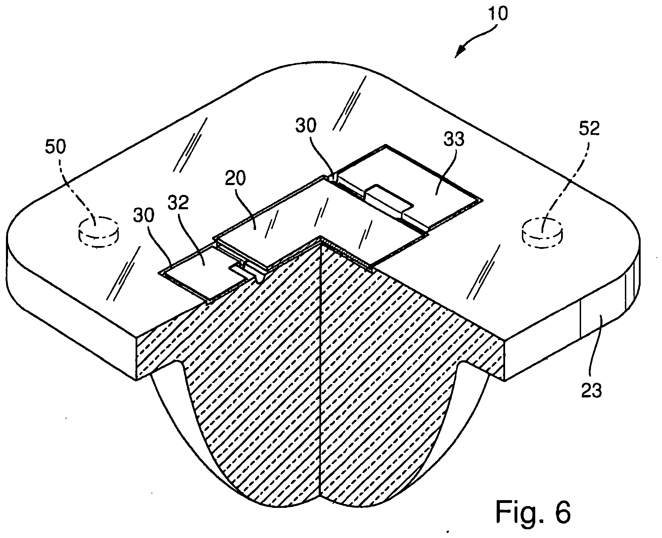

Die Abbildung der Figur 5 zeigt eine perspektivische Ansicht auf eine zweite ungefügte Ausführungsform einer Solarzelleneinheit 10. Nachfolgend werden nur die Unterschiede zu der Darstellung in der Figur 1 erläutert. Die Hauptkavität 30 weist eine um die erste Grundfläche 35 angeordnete zweite Grundfläche 40 und eine dritte Grundfläche 45 auf. Zwischen der ersten Grundfläche 35 und der zweiten Grundfläche 40 ist eine erste Teilkavität 42 und zwischen der ersten Grundfläche 35 und der dritten Grundfläche 45 eine zweite Teilkavität 44 ausgebildet. Die Tiefe und laterale Größe der Hautkavität 30 und der beiden Tellkavitäten 42 und 44 sind derart ausgeführt, dass nach dem Einbringen des Halbleiterkörpers 20 und den beiden Kontaktstreifen 32 und 32 sowohl der Halbleiterkörper 20 als auch die beiden Kontaktstreifen 32 und 32 nach dem Einbringen der Polymerkleberschicht 60 plan mit der Unterseite 24 des sekundären optischen Elements 22 abschließen. Ferner stehen an der Unterseite 24 des sekundären optischen Elements 22 eine erste zapfenförmige Ausformung 50 und eine zweite zapfenförmlge Ausformung 52 hervor. Die beiden Ausformungen sind als Zentrierhilfen zum Justieren auf eine Unterlage - nicht dargestellt - ausgebildet. In der Abbildung der Figur 6 wird eine perspektivische Ansicht auf die zweite nunmehr gefügte Ausführungsform der Solarzelleneinheit dargestellt in der Figur 5 gezeigt. Hinsichtlich der Bedeutung der Bezugszeichen wird auf die vorstehenden Erläuterungen verwiesen.

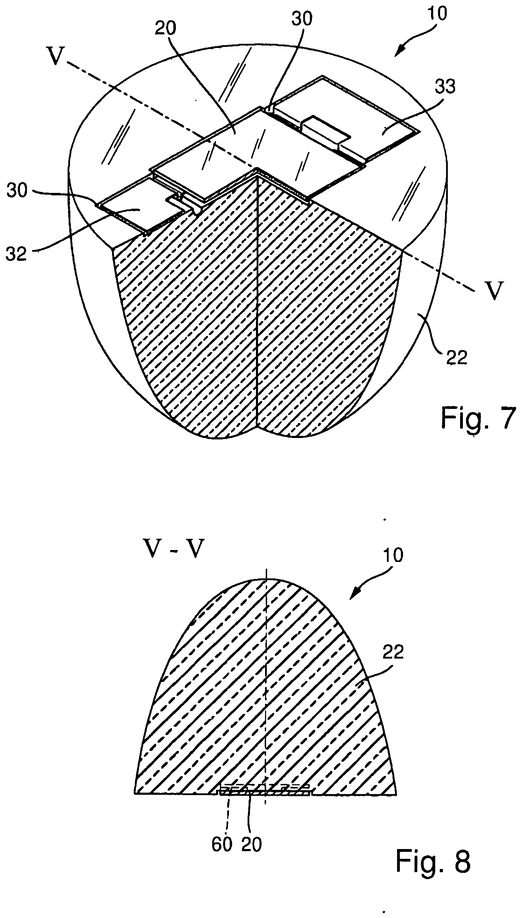

Die Abbildung der Figur 7 zeigt eine perspektivische Ansicht auf die dritte gefügte Ausführungsform einer Solarzelleneinheit 10 und die Abbildung der Figur 8 zeigt eine Querschnittsansicht entlang einer Linie V-V auf die Ausführungsform dargestellt in der Figur 7. Nachfolgend werden nur die Unterschiede zu der Darstellung in der Figur 1 erläutert. Es zeigt sich, dass das sekundäre optische Element 22 in Form eines halben Ellipsoids ohne einen umlaufenden kragenförmigen Wulst 23 ausgebildet Ist. Aus Gründen der Übersichtlichkeit ist bei der Darstellung der Abbildung der Figur 7 die Polymerkleberschicht 60 nicht in der Abbildung der Figur 8 jedoch dargestellt.

## Patentansprüche

1. Solarzelleneinheit (10) mit,
- einem als Solarzelle ausgebildeten Halbleiterkörper (20), aufweisend eine Vorderseite und eine Rückseite und wobei auf der Vorderseite ein erster elektrischer Anschlusskontaktbereich und auf Rückseite ein zweiter elektrischer Anschlusskontaktbereich ausgebildet ist, und der erste elektrische Anschlusskontaktbereich mit einem ersten Kontaktstreifen (32) und / oder mit einem zweiten Kontaktstreifen (33) elektrisch verschaltet ist, und
- einem sekundären optischen Element (22), wobei das sekundäre optische Element (22) Licht auf die Vorderseite des Halbleiterkörpers (20) führt, und das optische Element (22) eine Unterseite (24) aufweist, **wobei**
das sekundäre optische Element (22) an der Unterseite (24) mit Ausnahme eines zentralen Bereichs plan ausgeformt ist und in dem zentralen Bereich eine Hauptkavität (30) aufweist, wobei in einem mittleren Bereich der Hauptkavität (30) eine erste plane Grundfläche (35) ausgebildet ist und die Hauptkavität (30) den Halbleiterkörper (20) mit dem ersten Kontaktstreifen (32) und / oder dem zweiten Kontaktstreifen (33) aufnimmt und die erste Grundfläche (35) auf der Vorderseite des Halbleiterkörpers (20) angeordnet und mit dem Halbleiterkörper (20) kraftschlüssig verbunden ist und sowohl zwischen der ersten Grundfläche (35) und der Vorderseite des Halbleiterkörpers (20) als auch dem sekundären optischen Element (22) und dem ersten Kontaktstreifen (32) und / oder dem zweiten Kontaktstreifen (33) eine Polymerkleberschicht (60) ausgebildet ist,
die Rückseite des Halbleiterkörpers aus der Oberfläche des sekundären optischen Elements hervor steht, die beiden Kontaktstreifen (32) und (33) jeweils eine bogenförmige Ausformung aufweisen,
die Hauptkavität (30) eine um die erste Grundfläche (35) angeordnete zweite Grundfläche (40) und / oder dritte Grundfläche (45) aufweist und zwischen der ersten Grundfläche (35) und der zweiten Grundfläche (40) eine erste Teilkavität (42) zur Aufnahme einer der bogenförmigen Ausformungen und / oder zwischen der erste Grundfläche (35) und der dritten Grundfläche (45) eine zweite Teilkavität (44) zur Aufnahme einer der bogenförmigen Ausformungen ausgebildet ist, und das sekundäre optische Element (22) einstückig ausgebildet ist und aus einer Quarzglasverbindung besteht.

2. Solarzelleneinheit (10) nach Anspruch 1, **dadurch gekennzeichnet, dass** die erste Teilkavität (42) und die zweite Teilkavität (44) ausschließlich innerhalb der Hauptkavität (30) ausgebildet sind.

3. Solarzelleneinheit (10) nach Anspruch 1 oder 2, **dadurch gekennzeichnet, dass** die Unterseite (24) des sekundären optischen Elements (22) eine erste Ausformung (50) aufweist und die erste Ausformung (50) als Zentrierhilfe ausgebildet ist.

4. Solarzelleneinheit (10) nach Anspruch 3, **dadurch gekennzeichnet, dass** eine zweite Ausformung (52) ausgebildet ist und die erste Ausformung (50) und die zweite Ausformung (52) aus der Unterseite (24) hervorsteht.

5. Solarzelleneinheit (10) nach einem der Ansprüche 1 bis 4, **dadurch gekennzeichnet, dass** die Polymerkleberschicht (60) kissenartig und formschlüssig bis an den ersten Kontaktstreifen (32) und / oder den zweiten Kontaktstreifen (33) und bis an die Vorderseite des Halbleiterkörpers (20) ausgebildet ist.

6. Solarzelleneinheit (10) nach einem der Ansprüche 1 bis 5, **dadurch gekennzeichnet, dass** das sekundäre optische Element (22) trichterförmig oder ellipsenförmig ausgebildet ist.

7. Solarzelleneinheit (10) nach einem der Ansprüche 1 bis 6, **dadurch gekennzeichnet, dass** zwischen der ersten Grundfläche (35) und der Polymerkleberschicht (60) eine erste Haftvermittlerschicht ausgebildet ist.

8. Solarzelleneinheit (10) nach einem der Ansprüche 1 bis 7, **dadurch gekennzeichnet, dass** die erste Haftvermittlerschicht in der Hauptkavität (30) des sekundären optischen Elements (22) ausgebildet ist.

9. Solarzelleneinheit (10) nach einem der Ansprüche 1 bis 8, **dadurch gekennzeichnet, dass** zwischen der Vorderseite des Halbleiterkörpers (20) und der Polymerkleberschicht (60) eine zweite Haftvermittlerschicht ausgebildet ist.

10. Solarzelleneinheit (10) nach einem der Ansprüche 1 bis 9, **dadurch gekennzeichnet, dass** die Polymerkleberschicht (60) eine Kunststoffverbindung umfasst.

11. Solarzelleneinheit (10) nach einem der Ansprüche 1 bis 10, **dadurch gekennzeichnet, dass** die Polymerkleberschicht (60) eine Silikonverbindung umfasst.

## Claims

1. Solar cell unit (10) with
- a semiconductor body (20), which is constructed as a solar cell and has a front side and a rear side and wherein a first electrical terminal contact region is formed on the front side and a second electrical terminal contact region on the rear side, and the first electrical terminal contact region is electrically connected with a first contact strip (32) and/or with a second contact strip (33), and
a secondary optical element (22), wherein the secondary optical element (22) conducts light to the front side of the semiconductor body (20) and the optical element (22) has a lower side (24),
wherein the secondary optical element (22) is formed at the lower side (24) with the exception of the central region to be planar and has in the central region a main cavity (30), wherein a first planar base surface (35) is formed in a middle region of the main cavity (30) and the main cavity (30) receives the semiconductor body (20) with the first contact strip (32) and/or the second contact strip (33) and the first base surface (35) is arranged on the front side of the semiconductor body (20) and frictionally connected with the semiconductor body (20), and a polymer adhesive layer (60) is formed not only between the first base surface (35) and the front side of the semiconductor body (20), but also at the secondary optical element (22) and the first contact strip (32) and/or the second contact strip (33),
the rear side of the semiconductor body protrudes from the surface of the secondary optical element, the two contact strips (32 and 33) each have a curved shape, the main cavity (30) has a second base surface (40) and/or third base surface (45) arranged around the first base surface (35) and a first part cavity (42) for reception of one of the curved shaped portions is formed between the first base surface (35) and the second base surface (40) and/or a second part cavity (44) for reception of one of the curved shaped portions is formed between the first base surface (35) and the third base surface (45),
and the secondary optical element (22) is of integral construction and consists of a quartz glass compound.

2. Solar cell unit (10) according to claim 1, **characterised in that** the first part cavity (42) and the second part cavity (44) are formed exclusively within the main cavity (30).

3. Solar cell unit (10) according to claim 1 or 2, **characterised in that** the lower side (24) of the secondary optical element (22) has a first shaped portion (50) and the first shaped portion (50) is formed as a centring aide.

4. Solar cell unit (10) according to claim 3, **characterised in that** a second shaped portion (52) is formed and the first shaped portion (50) and the second shaped portion (52) protrude from the lower side (24).

5. Solar cell unit (10) according to any one of claims 1 to 4, **characterised in that** the polymer adhesive layer (60) is formed to be cushion-like and interlocking up to the first contact strip (32) and/or the second contact strip (33) and up to the front side of the semiconductor body (20).

6. Solar cell unit (10) according to any one of claims 1 to 5, **characterised in that** the secondary optical element (22) is formed to be funnel-shaped and/or elliptical.

7. Solar cell unit (10) according to any one of claims 1 to 6, **characterised in that** a first adhesion promoting layer is formed between the first base surface (35) and the polymer adhesive layer (60).

8. Solar cell unit (10) according to any one of claims 1 to 7, according to any one of claims 1 to 7, **characterised in that** the first adhesion-promoting layer is formed in the main cavity (30) of the secondary optical element (22).

9. Solar cell unit (10) according to any one of claims 1 to 8, **characterised in that** a second adhesion-promoting layer is formed between the front side of the semiconductor body (20) and the polymer adhesive layer (60).

10. Solar cell unit (10) according to any one of claims 1 to 9, **characterised in that** the polymer adhesive layer (60) comprises a synthetic material compound.

11. Solar cell unit (10) according to any one of claims 1 to 10, **characterised in that** the polymer adhesive layer (60) comprises a silicone compound.

## Revendications

1. Unité de cellules solaires (10), comprenant :
- un corps semi-conducteur (20) qui est réalisé sous la forme d'une cellule solaire, qui présente une face avant et une face arrière, et dans lequel une première zone de contact de raccordement électrique est réalisée sur la face avant et une seconde zone de contact de raccordement électrique est réalisée sur la face arrière, et la première zone de contact de raccordement électrique est connectée électriquement à une première bande de contact (32) et/ou à une seconde bande de contact (33), et
- un élément optique secondaire (22), dans lequel l'élément optique secondaire (22) guide la lumière sur la face avant du corps semi-conducteur (20), et l'élément optique (22) présente une face inférieure (24),
dans lequel l'élément optique secondaire (22) est formé de manière plane sur la face inférieure (24), à l'exception d'une zone centrale, et présente une cavité principale (30) dans la zone centrale, dans lequel une première surface de base plane (35) est réalisée dans une zone médiane de la cavité principale (30) et que la cavité principale (30) reçoit le corps semi-conducteur (20) avec la première bande de contact (32) et/ou la seconde bande de contact (33), et dans lequel la première surface de base (35) est disposée sur la face avant du corps semi-conducteur (20) et est reliée de manière mécanique au corps semi-conducteur (20), et dans lequel une couche de colle polymère (60) est réalisée aussi bien entre la première surface de base (35) et la face avant du corps semi-conducteur (20) qu'entre l'élément optique secondaire (22) et la première bande de contact (32) et/ou la seconde bande de contact (33), la face arrière du corps semi-conducteur fait saillie à partir de la surface de l'élément optique secondaire, les deux bandes de contact (32) et (33) présentent respectivement une partie saillante en forme d'arc, la cavité principale (30) présente une deuxième surface de base (40) et/ou une troisième surface de base (45) agencée(s) autour de la première surface de base (35) et une première cavité partielle (42) qui est destinée à recevoir l'une des parties saillantes en forme d'arc est réalisée entre la première surface de base (35) et la deuxième surface de base (40) et/ou une seconde cavité partielle (44) qui est destinée à recevoir l'une des parties saillantes en forme d'arc est réalisée entre la première surface de base (35) et la troisième surface de base (45), et l'élément optique secondaire (22) est réalisé d'un seul tenant et est constitué d'un composé de verre de quartz.

2. Unité de cellules solaires (10) selon la revendication 1, **caractérisée en ce que** la première cavité partielle (42) et la seconde cavité partielle (44) sont réalisées exclusivement à l'intérieur de la cavité principale (30).

3. Unité de cellules solaires (10) selon la revendication 1 ou 2, **caractérisée en ce que** la face inférieure (24) de l'élément optique secondaire (22) comporte une première partie saillante (50) et la première partie saillante (50) est réalisée sous la forme d'un auxiliaire de centrage.

4. Unité de cellules solaires (10) selon la revendication 3, **caractérisée en ce qu'**une seconde partie saillante (52) est réalisée et la première partie saillante (50) et la seconde partie saillante (52) font saillie à partir de la face inférieure (24).

5. Unité de cellules solaires (10) selon l'une quelconque des revendications 1 à 4, **caractérisée en ce que** la couche de colle polymère (60) est réalisée à la manière d'un coussin et par complémentarité de forme jusqu'à la première bande de contact (32) et/ou la seconde bande de contact (33) et jusqu'à la face avant du corps semi-conducteur (20).

6. Unité de cellules solaires (10) selon l'une quelconque des revendications 1 à 5, **caractérisée en ce que** l'élément optique secondaire (22) est réalisé sous la forme d'un entonnoir ou d'une ellipse.

7. Unité de cellules solaires (10) selon l'une quelconque des revendications 1 à 6, **caractérisée en ce qu'**une première couche d'agent adhésif est réalisée entre la première surface de base (35) et la couche de colle polymère (60).

8. Unité de cellules solaires (10) selon l'une quelconque des revendications 1 à 7, **caractérisée en ce que** la première couche d'agent adhésif est réalisée à l'intérieur de la cavité principale (30) de l'élément optique secondaire (22).

9. Unité de cellules solaires (10) selon l'une quelconque des revendications 1 à 8, **caractérisée en ce qu'**une seconde couche d'agent adhésif est réalisée entre la face avant du corps semi-conducteur (20) et la couche de colle polymère (60).

10. Unité de cellules solaires (10) selon l'une quelconque des revendications 1 à 9, **caractérisée en ce que** la couche de colle polymère (60) comprend un composé plastique.

11. Unité de cellules solaires (10) selon l'une quelconque des revendications 1 à 10, **caractérisée en ce que** la couche de colle polymère (60) comprend un composé de silicone.
